# EUROPÄISCHE PATENTSCHRIFT

(11) **EP 0 637 899 B1**
(45) Veröffentlichungstag und Bekanntmachung des Hinweises auf die Patenterteilung: **04.11.1998**
(21) Anmeldenummer: 94111826.7
(22) Anmeldetag: 29.07.1994
(51) Int. Cl.: H05B 33/14, H05B 33/10

(54) **Elektrolumineszierende Anordnung**
Electroluminescent arrangement
Arrangement électroluminescent

(30) Priorität: 02.08.1993 DE 4325885
(43) Veröffentlichungstag der Anmeldung: 08.02.1995
(73) Patentinhaber: BASF Aktiengesellschaft, 67063 Ludwigshafen (DE)
(72) Erfinder: Funhoff, Dirk, Dr., D-69126 Heidelberg (DE); Siemensmeyer, Karl, Dr., D-67227 Frankenthal (DE); Häussling, Lukas, Dr., D-55452 Laubenheim (DE); Etzbach, Karl-Heinz, Dr., D-67227 Frankenthal (DE); Haarer, Dietrich, Prof. Dr., D-95448 Bayreuth (DE); Simmerer, Juergen, D-95447 Bayreuth (DE)

(56) Entgegenhaltungen:
- EP-A- 0 357 443
- WO-A-88/04467

## Beschreibung

Eine elektrolumineszierende (EL) Anordnung ist dadurch charakterisiert, daß sie unter Anlegung einer elektrischen Spannung unter Stromfluß Licht aussendet. Derartige Anordnungen sind unter der Bezeichnung "Leuchtdioden" (LEDs = light emitting diodes) seit langem in der Technik bekannt. Die Emission von Licht kommt dadurch zustande, daß positive Ladungen ("Löcher", holes) und negative Ladungen ("Elektronen", electrons) unter Aussendung von Licht kombinieren.

Die in der Technik gebräuchlichen LEDs bestehen alle zum überwiegenden Teil aus anorganischen Halbleitermaterialien. Seit einigen Jahren sind jedoch EL-Anordnungen bekannt, deren wesentliche Bestandteile organische Materialien sind.

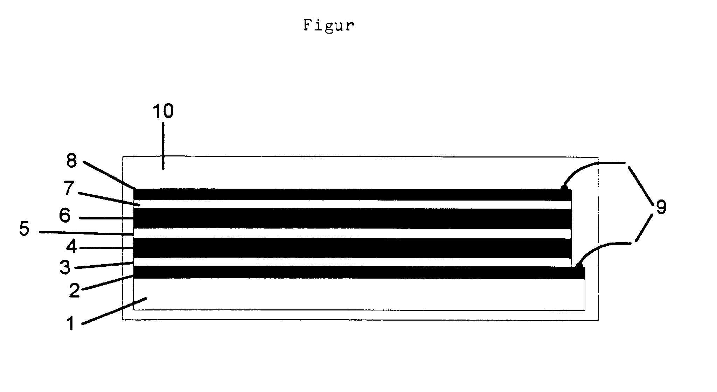

Diese organischen EL-Anordnungen enthalten in der Regel eine oder mehrere Schichten aus organischen Ladungstransportverbindungen. Der prinzipielle Aufbau ist in der Figur dargestellt. Die Zahlen 1 bis 10 bedeuten dabei:
1 Träger, Substrat
2 Basiselektrode
3 Löcher-injizierende Schicht
4 Löcher-transportierende Schicht
5 Emitter-Schicht
6 Elektronen-transportierende Schicht
7 Elektronen-injizierende Schicht
8 Topelektrode
9 Kontakte
10 Umhüllung, Verkapselung

Dieser Aufbau stellt den allgemeinsten Fall dar und kann vereinfacht werden, indem einzelne Schichten weggelassen werden, so daß eine Schicht mehrere Aufgaben übernimmt. Im einfachsten Fall besteht eine EL-Anordnung aus zwei Elektroden, zwischen denen sich eine organische Schicht befindet, die alle Funktionen - inklusive der der Emission von Licht - erfüllt. Derartige Systeme sind z.B. in der Anmeldung WO 9013148 auf der Basis von Poly-[p-phenylenvinylen] beschrieben.

Gegenstand der Erfindung sind die in den Ansprüchen beschriebenen Anordnungen, die eine oder mehrere, auch von ihrer Funktion her kombinierbare Schichten 3 - 7 enthalten. Bei dem Aufbau der EL-Anordnung kann z.B. auf die Elektronenleiterschicht und die elektronen-injizierende Schicht verzichtet werden. Die EL-Anordnung würde dann z.B. neben den Elektroden und dem Substrat aus den Schichten 3 bis 5 bestehen.

Erfindungsgemäß werden unter Ladungstransportverbindungen alle Verbindungen verstanden, die in irgendeiner Art und Weise Ladungen (Löcher und/oder Elektronen) transportieren. Darunter fallen auch ausdrücklich diejenigen Verbindungen, die Bestandteile der Emitter-Schicht sind, also photolumineszierende Materialien darstellen, wie z.B. Fluoreszenzfarbstoffe.

In der Literatur wird eine Vielzahl von organischen Verbindungen beschrieben, die Ladungen (Löcher und/oder Elektronen) transportieren. Verwendet werden überwiegend niedermolekulare Substanzen, die z.B. im Hochvakuum aufgedampft werden. Einen guten Überblick über die Substanzklassen und ihre Verwendung geben z.B. die Veröffentlichungen EP-A-387715, US-A-4539507, 4720432 und 4769292. Im Prinzip kann man z.B. alle Substanzen verwenden, die als Photoleiter aus der Elektrophotographie bekannt sind.

Allen diesen EL-Anordnungen, welche auf niedermolekularen Verbindungen basieren, ist gemeinsam, daß sie keine ausreichende Betriebs-Lebensdauer haben. Während des Betriebs werden die organischen Leuchtdioden sehr heiß (> 100°C), und dies führt zu einer Veränderung (bis hin zur Zerstörung) der Schichten, so daß dann eine Leistungsminderung oder völliger Verlust der Funktion eintritt.

Diese Probleme sollten bei der Verwendung von Polymeren in EL-Anordnungen weniger stark ausgeprägt auftreten. Schichten, die Polymere enthalten, sind jedoch nur wenige beschrieben. So wird z.B. eine EL-Anordnung in der japanischen Offenlegungsschrift JP 4028197 geschildert, welche Polyvinylcarbazol als Bestandteil der Emitterschicht enthält. Das Aufbringen von löslichen Polymeren, wie Polyvinylcarbazol, geschieht mittels Gießen oder Aufschleudern (spin-coating) verdünnter Lösungen. Nachteilig bei diesem Verfahren ist, daß mehrere Schichten auf diese Art nicht aufgebracht werden können, da das Lösungsmittel für die zweite Schicht die erste Schicht anlöst oder zumindest anquillt. Dies führt dann zu einer Vermischung der beiden Schichten an der Grenzfläche und damit zu einer Verringerung der Effizienz. Diese Probleme werden in US-Patentschrift 4539507 ausführlich beschrieben.

Außerdem ist zu beachten, daß die thermische Stabilität von Polymerschichten nicht nur chemisch (Zersetzung), sondern auch physikalisch durch ihre Glas- oder Schmelztemperatur begrenzt ist.

Weitere Beispiele für den Einsatz von Polymeren in EL-Anordnungen sind Poly[p-phenylenvinylen] (PPV) und Polyimide. Die Verwendung von PPV in EL-Anordnungen wird in den Schutzrechten EP-A-443861, WO-A-9013148, 9203490 und 9203491 beschrieben. Als Vorteil kann die hohe thermische Stabilität des PPV angeführt werden, welches außerdem unlöslich ist.

Polyimid-Schichten werden durch Aufdampfen entsprechender Comonomerer im Hochvakuum und anschließende thermische Bildung des Polyimids erhalten (siehe EP-A-449125). Diese Polymeren sind ebenfalls unlöslich.

Für Anwendungen im EL-Bereich (insbesondere Anzeigeelemente, Displays) gilt diese Unlöslichkeit wegen der dadurch nicht mehr möglichen Photostrukturierbarkeit als Nachteil. Außerdem beschränkt die zur Herstellung der Polymeren erforderliche thermische Behandlung der Schichtträger die Auswahl auf hochtemperaturstabile Substrate, z.B. Glas.

Es wurde nun gefunden, daß sich die beschriebenen Nachteile bei den erfindungsgemäßen EL-Anordnungen vermeiden lassen. Der Aufbau dieser EL-Anordnungen entspricht prinzipiell dem in der Figur gezeigten Schema, wobei, wie schon angegeben, die Zahl der organischen Schichten vermindert werden kann, wenn einzelne Schichten mehrere Funktionen übernehmen.

Bei dem erfindungsgemäßen schichtweisen Aufbau der EL-Anordnung werden die Bestandteile der einzelnen Schichten thermisch oder besonders bevorzugt mit aktinischer Strahlung (UV-Licht, sichtbares Licht, Elektronenstrahlen oder Röntgenstrahlen) vernetzt. Zunächst wird ein geeignetes Substrat beschichtet. Als Substrate eignen sich z.B. leitfähig beschichtete Gläser und Folien, die mechanisch stabil sind. Das Substrat und die Elektroden sollten bei der Wellenlänge des emittierten Lichtes möglichst wenig absorbieren. In der Regel wird eine entsprechende Lösung, die die Ladungstransportverbindungen neben weiteren, optionalen Bestandteilen wie Bindemitteln, Reaktivverdünnern, Vernetzern und thermischen oder Photo-Initiatoren, enthält, auf ein Substrat aufgeschleudert oder gerakelt, und nach eventueller Trocknung wird der entstandene Film thermisch oder, besonders bevorzugt, mittels aktinischer Strahlung vernetzt. Vorteil letzterer Ausführungsform ist, daß das Substrat kaum thermisch belastet wird. In jedem Fall kann - je nach geplantem Aufbau - nach der Vernetzung sogleich die nächste Schicht aufgebracht werden. Aufgrund der Ausbildung eines unlöslichen polymeren Netzwerks in der gerade behandelten Schicht kann eine Vermischung der frisch-aufgebrachten mit der bereits vernetzten Schicht nicht auftreten. Bei der strahlungsinduzierten Vernetzung können die Schicht oder Schichten durch bildmäßige Belichtung nach bekannten Methoden natürlich auch strukturiert werden, wobei nicht belichtete Stellen durch Auswaschen entfernt werden können. Auf Vernetzung basierende, photostrukturierbare Systeme sind in der Technik bekannt (Druckplatten, Photoresiste).

Ebenfalls möglich ist die Kombination von vernetzten mit unvernetzten Schichten, die auf bekannte Art erhalten werden, beispielsweise durch Aufdampfen oder Aufrakeln und gegebenenfalls anschließendes Fixieren.

Als ladungstransportierende Verbindungen in den Schichten können erfindungsgemäß alle Verbindungen verwendet werden, die in irgendeiner Art und Weise Ladungen (Löcher und/oder Elektronen) transportieren. Darunter fallen, wie schon gesagt, auch ausdrücklich diejenigen Verbindungen, die Bestandteile der Emitter-Schicht sind, also photolumineszierende Materialien darstellen, wie Fluoreszenzfarbstoffe. Besonders geeignet sind solche Verbindungen, die anionisch, kationisch oder vorzugsweise radikalisch polymerisierbare Gruppen tragen. Ebenfalls bevorzugt sind solche Ladungstransportverbindungen, welche zur Photocycloaddition fähige Gruppen tragen.

Als Grundkörper können aufgeführt werden: tertiäre aromatische Amine, Oxadiazole, Thiadiazole, Benzoxazole, Benztriazole, Phthalocyanine, kondensierte aromatische Systeme, wie Perylene, Pyrene oder Coronene oder Polyenverbindungen, welche vorzugsweise zusätzlich kationisch oder radikalisch polymerisierbare Gruppen oder zur Photocycloaddition fähige Gruppen tragen. Derartige Verbindungen werden vorzugsweise in die Schichten 3, 4, 6 und 7, oder in Kombinationen derselben, eingebracht. Ebenfalls möglich ist die Verwendung von Farbstoffen, die anionisch, kationisch oder vorzugsweise radikalisch polymerisierbare Gruppen oder zur Photocycloaddition fähige Gruppen aufweisen. Die daraus erhaltenen polymeren Netzwerke werden bevorzugt als Schicht 5 verwendet.

Als Ladungstransportverbindungen kommen z.B. in Betracht: 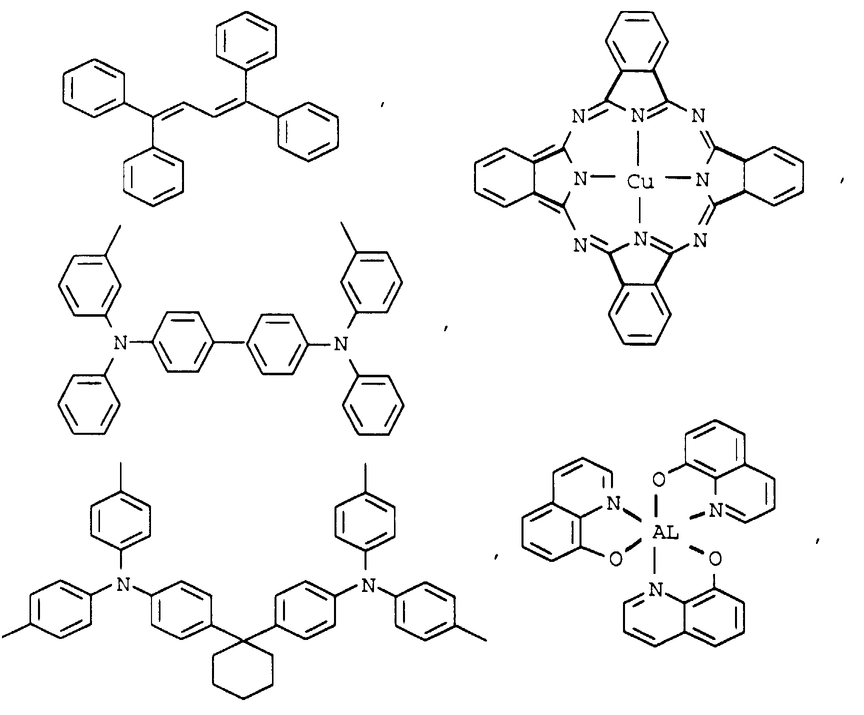 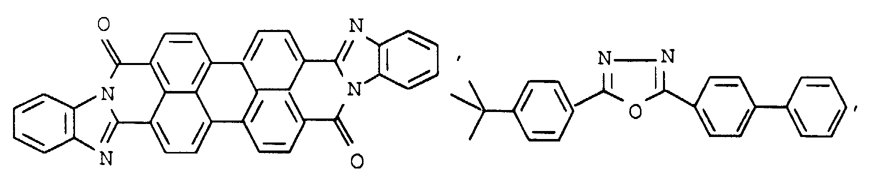 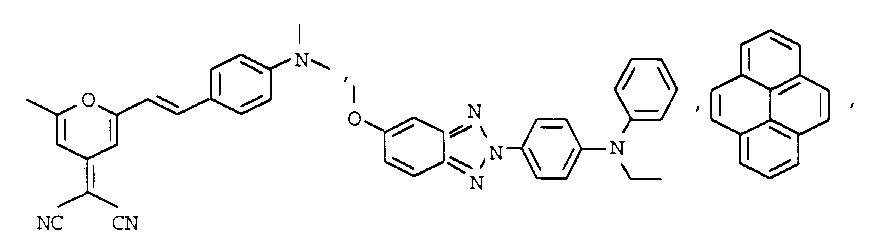 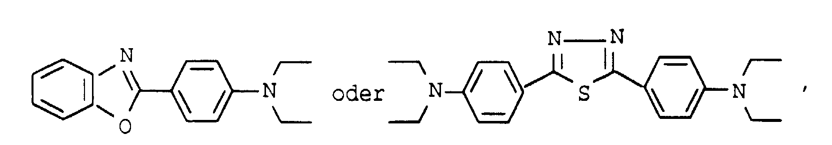 wobei diese Verbindungen noch Substituenten, vorzugsweise C₁- bis C₄-Alkyl, Methoxy, Ethoxy oder Cyan, tragen können.

Radikalisch polymerisierbare Gruppen sind solche, bei denen die Polymerisation mit Radikalen gestartet wird. Beispiele derartiger Gruppen sind insbesondere Vinylcarbonylverbindungen wie Acrylate, Methacrylate oder Maleinsäurederivate.

Unter kationisch polymerisierbaren Gruppen werden Gruppen verstanden, die mit Protonensäuren oder Lewis-Säuren unter Bildung von Polymeren reagieren. Beispiele für derartige Verbindungen sind Vinylether und Epoxide.

Anionisch polymerisierbare Verbindungen sind z.B. Cyanacrylate, Methacrylate oder Styrol.

An einem ladungstransportierenden Molekül können natürlich eine oder mehrere anionisch, kationisch oder vorzugsweise radikalisch polymerisierbare Gruppen gebunden sein. Die Verwendung von mehr als einer anionisch, kationisch oder radikalisch polymerisierbaren Gruppe ist bevorzugt, da die Netzwerk-Bildung dabei leichter gelingt.

Beispiele derartiger Verbindungen sind: 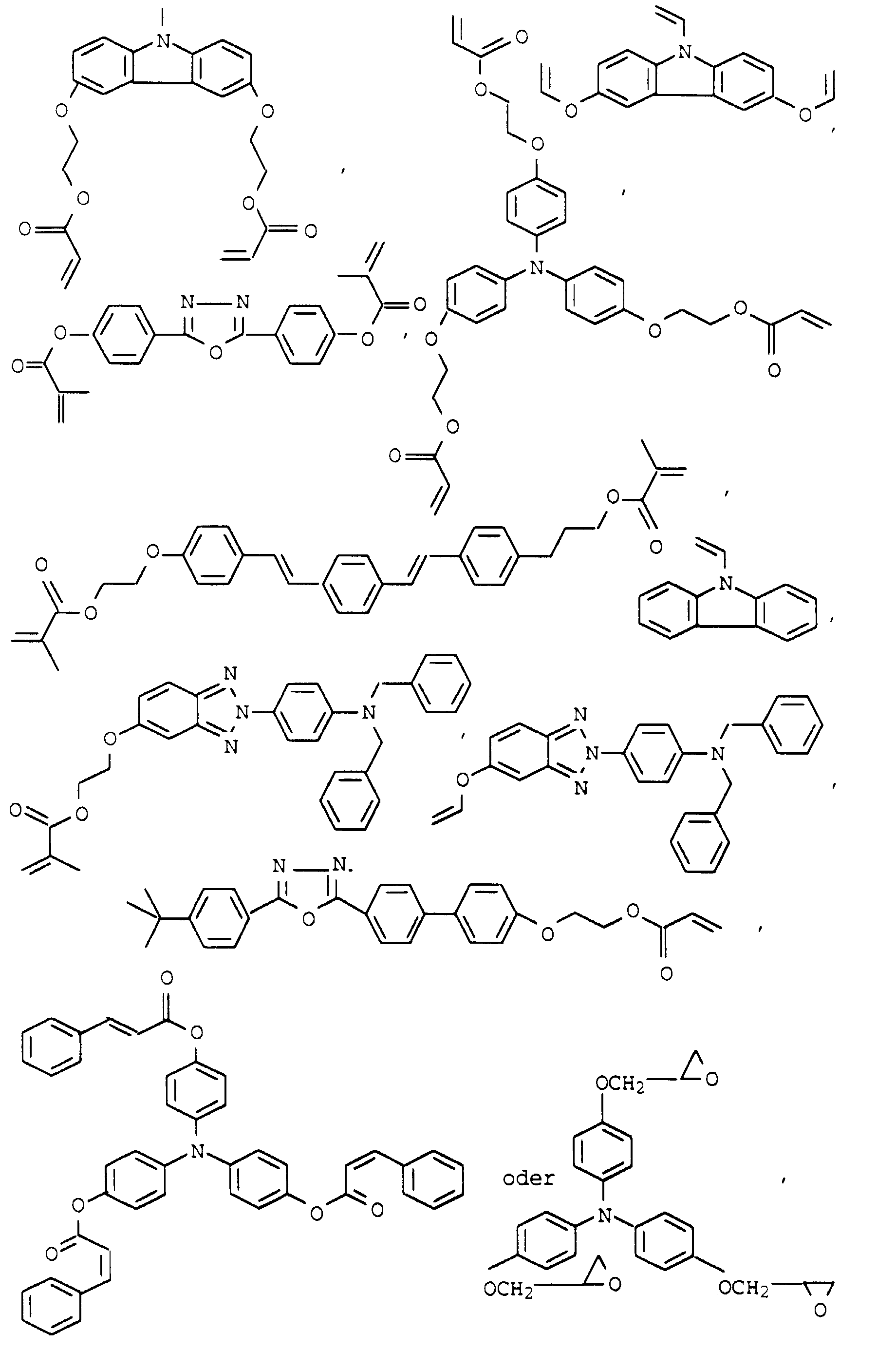 wobei auch diese Verbindungen noch Substituenten, vorzugsweise die bereits genannten, tragen können.

Zur Photocycloaddition fähige Seitengruppen sind ebenfalls bevorzugt als Substituenten für die erfindungsgemäßen Ladungstransportverbindungen. Beispiele derartiger Seitengruppen sind: 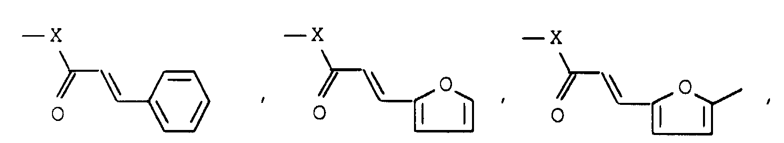 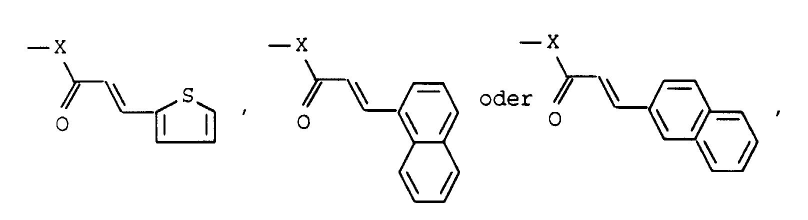 wobei X O oder NR ist und die Reste noch weiter, beispielsweise durch Methyl oder Methoxy substituiert sein können und R Wasserstoff oder C₁- bis C₆-Alkyl, vorzugsweise Methyl oder Ethyl, bedeutet.

Anstelle einheitlicher zur Vernetzung führender Substituenten können auch Kombinationen der verschiedenen vernetzbaren Substituenten an einem Ladungstransportmolekül verwendet werden. So kann z.B. an einem Ladungstransportmolekül eine radikalisch vernetzbare Gruppe, wie ein Acrylsäureester, neben einer zur Photocycloaddition fähigen Gruppe, z.B. einem Zimtsäurederivat vorliegen.

Neben den Ladungstransportverbindungen können die Lösungen zur Herstellung der erfindungsgemäßen Schichten, wie bereits gesagt, beispielsweise noch (thermische und photochemische) Initiatoren, Bindemittel, Reaktivverdünner, Vernetzer und Verlaufshilfsmittel enthalten, die dem Fachmann aus der Lacktechnik bekannt sind.

Für den Fall, daß die Ladungstransportverbindungen keine vernetzbaren Gruppen haben, d.h., wenn sie nicht an der Netzwerk-Bildung teilnehmen, müssen die genannten Zusätze die Bildung des unlöslichen Netzwerks übernehmen, in dem die Ladungstransportverbindungen dann fixiert sind. Als Bindemittel werden dann zweckmäßigerweise noch lösliche Polymere verwendet, die vernetzbare Seitengruppen tragen, wie sie bereits für die Ladungstransportverbindungen aufgeführt sind, also Acrylate, Methacrylate oder Maleinsäurederivate, Vinylether oder Epoxide oder zur Photocycloaddition fähige Gruppen. Ein Beispiel für ein Polymer mit zur Photocycloaddition fähigen Seitengruppen ist Poly-[zimtsäurevinylester].

Zur Herstellung der erfindungsgemäßen Schichten werden zweckmäßigerweise die ladungstransportierenden Verbindungen gegebenenfalls zusammen mit einem kationisch oder radikalisch wirkenden Initiator, Bindemittel und Reaktivverdünner in einem Lösungsmittel, in dem sie gut löslich sind, gelöst und mittels einer Rakel oder einer Schleuder auf das bereits mit einer Elektrode beschichtete Substrat aufgebracht. Nach dem Verdunsten des Lösungsmittels, was ggf. durch leichtes Erwärmen beschleunigt werden kann, wird der resultierende Film mittels aktinischer Strahlung oder durch Erwärmung vernetzt. Die entsprechenden Verfahren (z.B. UV-Härtung, Elektronenstrahlhärtung) sind aus der Lacktechnologie bekannt und bieten demgegenüber keine Besonderheiten, üblicherweise werden bei UV Wellenlängen von 200 bis 450 nm und bei Elektronenstrahlen Energien von 0,3 bis 1 MeV verwendet. Bei der durch Strahlung bewirkten Vernetzung lassen sich die Schichten direkt strukturieren, was z.B. für die Display-Herstellung wichtig ist. Dies geschieht in der Regel analog zu den aus der Resist-Technologie bekannten Verfahren.

Die erhaltene, vernetzte Schicht ist thermisch stabil, unlöslich und mechanisch belastbar. Je nach gewünschter Ausführung können analog weitere Schichten oder sofort die zweite Elektrode, z.B. durch Aufdampfen, aufgebracht werden. Derartige EL-Anordnungen zeichnen sich durch eine besonders gute thermische Belastbarkeit aus.

### Beispiel 1

5 g Vinylcarbazol werden zusammen mit 0.1 g der Verbindung der Formel 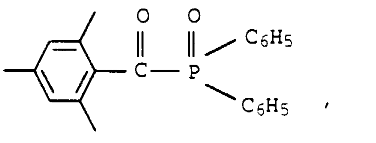 2 g Polyvinylcarbazol und 2 g Trimethylolpropantriacrylat in 200 ml Methoxypropanol gelöst. Diese Lösung wird mittels eines Spin-Coaters auf eine mit leitfähigem ITO (Indium-Zinn-Oxid) beschichtete Glasscheibe aufgeschleudert. Diese Scheibe wird anschließend auf einer Heizplatte für 3 min auf 90°C erwärmt. Die Schichtdicke nach Trocknung beträgt 240 nm.

Die erhaltene Schicht wird anschließend 10 min mit einer Quecksilber-Hochdrucklampe (HBO) bestrahlt. Dadurch tritt Vernetzung ein, die Schicht ist danach in Methoxypropanol unlöslich.

Anschließend wird auf diese Schicht eine Emitter-Schicht aufgebracht. Dazu wird eine Lösung von 0.01 g DCM (s. Beispiel 2) und 0.99 g Poly-[zimtsäurevinylester] in 30 ml Toluol aufgeschleudert, getrocknet und durch Bestrahlung mit einer HBO-Lampe vernetzt. Die Schichtdicke beträgt 190 nm.

Anschließend werden die Schichten für eine Stunde bei 100°C im Vakuumtrockenschrank getrocknet.

Als Top-Elektrode wird eine Aluminiumelektrode verwendet. Das Aluminium wird in üblicher Weise aufgedampft, die Schichtdicke beträgt 30 nm.

Die solcherart hergestellte elektrolumineszierende Anordnung leuchtet bei Anlegen einer Spannung von 87 V orange-rot.

### Beispiel 2

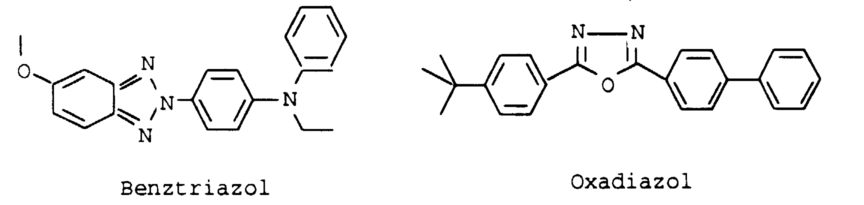

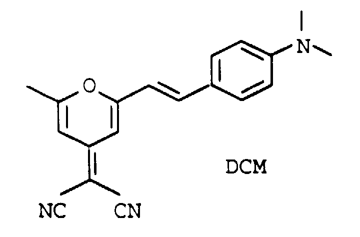

Auf ein mit ITO beschichtetes Glassubstrat wird eine Lösung von 0.1 g des Benztriazols der obigen Formel und 0.4 g Poly[zimtsäurevinylester] in 17 ml Toluol aufgeschleudert. Die so erhaltene Schicht wird sofort durch 5 minütige Bestrahlung mit einer HBO-Lampe vernetzt. Anschließend wird auf diese Schicht eine Lösung von 0.01 g DCM und 0.99 g Poly-[zimtsäurevinylester] in 30 ml Toluol aufgeschleudert und durch Bestrahlung mit einer HBO-Lampe vernetzt.

Anschließend wird die Prozedur mit einer Lösung von 0.3 g des Oxadiazols der angegebenen Formel und 0.7 g Poly[zimtsaurevinylester] in 30 ml Toluol wiederholt. Die Gesamtdicke aller drei Schichten beträgt dann 650 nm; sie werden anschließend eine Stunde bei 100°C im Vakuumtrockenschrank getrocknet.

Als Top-Elektrode wird wie in Beispiel 1 eine Aluminiumelektrode verwendet. Deren Schichtdicke beträgt 20 nm. Die solcherart hergestellte elektrolumineszierende Anordnung leuchtet bei Anlegen einer Spannung von 93 V orange-rot.

## Patentansprüche

1. Elektrolumineszierende Anordnung, enthaltend eine oder mehrere organische Schichten 3, 4, 5, 6 und/oder 7, dadurch gekennzeichnet, daß mindestens eine der Schichten durch thermische oder strahlungsinduzierte Vernetzung erhalten wird, daß pro Schicht mindestens eine ladungstransportierende Verbindung enthalten ist und daß eine der Schichten eine Emitterschicht 5 ist, welche ein organisches, lichtemittierendes Material enthält.

2. Elektrolumineszierende Anordnung, enthaltend eine oder mehrere organische Schichten 3, 4, 5, 6 und/oder 7, welche durch thermische oder strahlungsinduzierte Vernetzung erhalten werden, dadurch gekennzeichnet, daß die Schichten mindestens ein vernetzbares polymeres Bindemittel und/oder mindestens eine vernetzbare niedermolekulare Verbindung sowie zusätzlich mindestens eine gegebenenfalls vernetzbare Gruppen enthaltende Ladungstransportverbindung enthalten und daß eine der Schichten eine Emitterschicht 5 ist, welche ein organisches, lichtemittierendes Material enthält.

3. Elektrolumineszierende Anordnung nach Anspruch 2, dadurch gekennzeichnet, daß das vernetzbare polymere Bindemittel und/oder die vernetzbare niedermolekulare Verbindung radikalisch, anionisch oder kationisch vernetzbare oder zur Photocycloaddition fähige Gruppen enthält.

4. Elektrolumineszierende Anordnung gemäß Anspruch 1, enthaltend eine oder mehrere organische Schichten, welche durch thermische oder strahlungsinduzierte Vernetzung von ladungstransportierenden Verbindungen erhalten werden.

5. Elektrolumineszierende Anordnung gemäß den Ansprüchen 1 bis 4 mit Schichten in Dicken zwischen 10 nm und 10 µm.

6. Elektrolumineszierende Anordnung gemäß den Ansprüchen 1 bis 4, dadurch gekennzeichnet, daß eine oder mehrere Schichten durch Vernetzung mit UV-Strahlung erhalten werden.

7. Elektrolumineszierende Anordnung gemäß Anspruch 6, dadurch gekennzeichnet, daß die verwendete UV-Strahlung im Wellenlängenbereich zwischen 200 und 450 nm liegt.

8. Elektrolumineszierende Anordnung gemäß den Ansprüchen 1 bis 4, dadurch gekennzeichnet, daß eine oder mehrere Schichten durch Vernetzung mit Elektronenstrahlen erhalten werden.

9. Elektrolumineszierende Anordnung gemäß Anspruch 8, dadurch gekennzeichnet, daß die verwendeten Elektronenstrahlen Energien von 0.3 - 1 MeV haben.

10. Elektrolumineszierende Anordnung gemäß den Ansprüchen 1 bis 4, dadurch gekennzeichnet, daß in der oder den Schichten als ladungstransportierende Verbindungen tertiäre aromatische Amine, Oxadiazole, Thiadiazole, Benzoxazole, Benztriazole, kondensierte aromatische Systeme oder Polyenverbindungen verwendet werden.

11. Elektrolumineszierende Anordnung gemäß den Ansprüchen 1 bis 4, dadurch gekennzeichnet, daß in der oder den Schichten als ladungstransportierende Verbindungen tertiäre aromatische Amine, Oxadiazole, Thiadiazole, Benzoxazole, Benztriazole, Phthalocyanine, kondensierte aromatische Systeme oder Polyenverbindungen mit anionisch, kationisch oder radikalisch polymerisierbaren Gruppen verwendet werden.

12. Elektrolumineszierende Anordnung gemäß den Ansprüchen 1 bis 4, dadurch gekennzeichnet, daß in der oder den Schichten als ladungstransportierende Verbindungen tertiäre aromatische Amine, Oxadiazole, Thiadiazole, Benzoxazole, Benztriazole, Phthalocyanine, kondensierte aromatische Systeme oder Polyenverbindungen mit zur Photocycloaddition fähigen Gruppen verwendet werden.

13. Elektrolumineszierende Anordnung gemäß Anspruch 11, dadurch gekennzeichnet, daß als ladungstransportierende Verbindungen solche mit radikalisch polymerisierbaren Gruppen verwendet werden.

14. Elektrolumineszierende Anordnung gemäß Anspruch 13, dadurch gekennzeichnet, daß die ladungstransportierenden Verbindungen als radikalisch polymerisierbare Gruppen gegebenenfalls substituierte Vinylreste tragen.

15. Elektrolumineszierende Anordnung gemäß Anspruch 14, dadurch gekennzeichnet, daß die gegebenenfalls substituierten Vinylreste Vinylcarbonylgruppen sind oder diese enthalten.

16. Elektrolumineszierende Anordnung gemäß Anspruch 12, dadurch gekennzeichnet, daß die zur Photocycloaddition fähigen Gruppen die gegebenenfalls substituierten Struktureinheiten 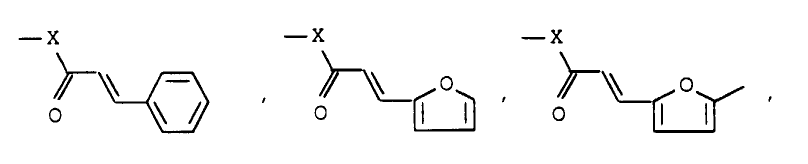 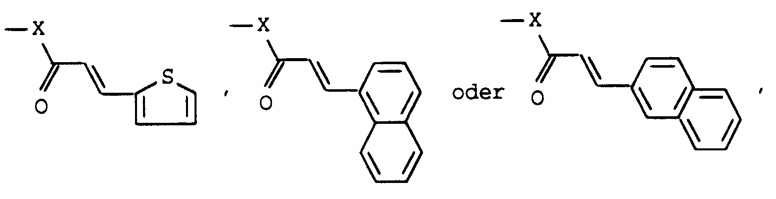 wobei X O oder NR ist und R Wasserstoff oder C₁- bis C₆-Alkyl bedeutet,
enthalten.

17. Elektrolumineszierende Anordnung gemäß Anspruch 10, dadurch gekennzeichnet, daß als tertiäre aromatische Amine triaryl- substituierte Verbindungen verwendet werden.

18. Elektrolumineszierende Anordnung gemäß den Ansprüchen 1 bis 4, dadurch gekennzeichnet, daß eine oder mehrere Schichten durch thermische Vernetzung erhalten werden.

19. Elektrolumineszierende Anordnung gemäß Anspruch 18, dadurch charakterisiert, daß die thermische Vernetzung bei Temperaturen von 50 bis 250°C, bevorzugt von 60 bis 150°C, durchgeführt wird.

## Claims

1. An electroluminescent arrangement, containing one or more organic layers 3, 4, 5, 6 or 7, wherein at least one of the layers is obtained by thermal or radiation-induced crosslinking, at least one charge-transporting compound is present per layer and one of the layers is an emitter layer 5 which contains an organic, light-emitting material.

2. An electroluminescent arrangement, containing one or more organic layers 3, 4, 5, 6 or 7 which are obtained by thermal or radiation-induced crosslinking, wherein the layers contain at least one crosslinkable polymeric binder or at least one crosslinkable low molecular weight compound and additionally at least one charge transport compound containing groups which may be crosslinkable and one of the layers is an emitter layer 5 which contains an organic, light-emitting material.

3. An electroluminescent arrangement as claimed in claim 2, wherein the crosslinkable polymeric binder or the crosslinkable low molecular weight compound contains groups capable of free radical, anionic or cationic crosslinking or groups capable of photocycloaddition.

4. An electroluminescent arrangement as claimed in claim 1, containing one or more organic layers which are obtained by thermal or radiation-induced crosslinking of charge-transporting compounds.

5. An electroluminescent arrangement as claimed in any of claims 1 to 4, having layers from 10 nm to 10 µm thick.

6. An electroluminescent arrangement as claimed in any of claims 1 to 4, wherein one or more layers are obtained by crosslinking with UV radiation.

7. An electroluminescent arrangement as claimed in claim 6, wherein the UV radiation used has a wavelength of from 200 to 450 nm.

8. An electroluminescent arrangement as claimed in any of claims 1 to 4, wherein one or more layers are obtained by crosslinking with electron beams.

9. An electroluminescent arrangement as claimed in claim 8, wherein the electron beams used have energies of 0.3-1 MeV.

10. An electroluminescent arrangement as claimed in any of claims 1 to 4, wherein tertiary aromatic amines, oxadiazoles, thiadiazoles, benzoxazoles, benzotriazoles, fused aromatic systems or polyene compounds are used as charge-transporting compounds in the layer or layers.

11. An electroluminescent arrangement as claimed in any of claims 1 to 4, wherein tertiary aromatic amines, oxadiazoles, thiadiazoles, benzoxazoles, benzotriazoles, phthalocyanines, fused aromatic systems or polyene compounds having groups capable of anionic, cationic or free radical polymerization are used as charge-transporting compounds in the layer or layers.

12. An electroluminescent arrangement as claimed in any of claims 1 to 4, wherein tertiary aromatic amines, oxadiazoles, thiadiazoles, benzoxazoles, benzotriazoles, phthalocyanines, fused aromatic systems or polyene compounds having groups capable of photocycloaddition are used as charge-transporting compounds in the layer or layers.

13. An electroluminescent arrangement as claimed in claim 11, wherein the charge-transporting compounds used are those having groups capable of free radical polymerization.

14. An electroluminescent arrangement as claimed in claim 13, wherein the charge-transporting compounds carry unsubstituted or substituted vinyl radicals as groups capable of free radical polymerization.

15. An electroluminescent arrangement as claimed in claim 14, wherein the unsubstituted or substituted vinyl radicals are vinylcarbonyl groups or contain these.

16. An electroluminescent arrangement as claimed in claim 12, wherein the groups capable of photocycloaddition contain the unsubstituted or substituted structural units 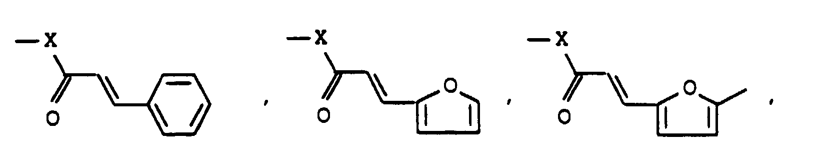 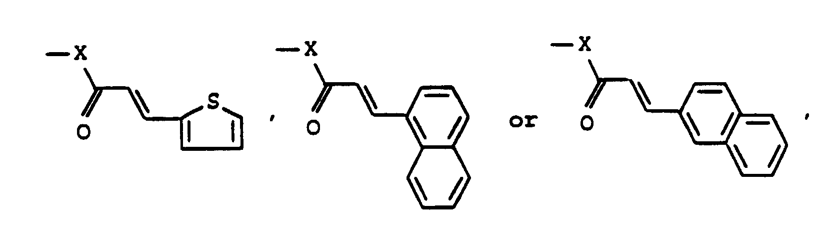 where X is O or NR and R is hydrogen or C₁-C₆-alkyl.

17. An electroluminescent arrangement as claimed in claim 10, wherein the tertiary aromatic amines used are triaryl-substituted compounds.

18. An electroluminescent arrangement as claimed in any of claims 1 to 4, wherein one or more layers are obtained by thermal crosslinking.

19. An electroluminescent arrangement as claimed in claim 18, wherein the thermal crosslinking is carried out at from 50 to 250°C, preferably from 60 to 150°C.

## Revendications

1. Dispositif électroluminescent, contenant une ou plusieurs couches organiques 3, 4, 5, 6 et/ou 7, caractérisé en ce qu'au moins une des couches est obtenue par réticulation thermique ou induite par des rayonnements, et en ce qu'il contient au moins un composé de transfert de charge par couche et en ce que l'une des couches est une couche d'émission 5 contenant un matériau organique émettant de la lumière.

2. Dispositif électroluminescent, contenant une ou plusieurs couches organiques 3, 4, 5, 6 et/ou 7 obtenues par réticulation thermique ou induite par des rayonnements, caractérisé en ce que les couches contiennent au moins un liant polymère réticulable et/ou au moins un composé à bas poids moléculaire réticulable ainsi qu'en outre au moins un composé de transfert de charge contenant éventuellement des groupements réticulables et en ce que l'une des couches est une couche d'émission 5 contenant un matériau organique émettant de la lumière.

3. Dispositif électroluminescent selon la revendication 2, caractérisé en ce que le liant polymère réticulable et/ou le composé à bas poids moléculaire réticulable contiennent des groupements réticulables par voie radicalaire, anionique ou cationique ou aptes à la photocycloaddition.

4. Dispositif électroluminescent selon la revendication 1, contenant une ou plusieurs couches organiques obtenues par réticulation thermique ou induite par des rayonnements de composés de transfert de charge.

5. Dispositif électroluminescent selon l'une quelconque des revendications 1 à 4 ayant des couches d'une épaisseur de 10 nm à 10 µm.

6. Dispositif électroluminescent selon l'une quelconque des revendications 1 à 4 caractérisé en ce qu'une ou plusieurs couches sont obtenues par réticulation au moyen de rayonnement UV.

7. Dispositif électroluminescent selon la revendication 6, caractérisé en ce que le rayonnement UV utilisé se situe dans le domaine de longueur d'ondes compris entre 200 et 450 nm.

8. Dispositif électroluminescent selon l'une quelconque des revendications 1 à 4 caractérisé en ce qu'une ou plusieurs couches sont obtenues par réticulation au moyen de rayonnements électroniques.

9. Dispositif électroluminescent selon la revendication 8, caractérisé en ce que les rayonnements électroniques utilisés ont une énergie de 0,3-1 MeV.

10. Dispositif électroluminescent selon l'une quelconque des revendications 1 à 4 caractérisé en ce qu'on utilise, dans la ou les couches, des amines aromatiques tertiaires, des oxadiazoles, des thiadiazoles, des benzoxazoles, des benzotriazoles, des systèmes aromatiques condensés ou des polyènes, en tant que composés de transfert de charge.

11. Dispositif électroluminescent selon l'une quelconque des revendications 1 à 4 caractérisé en ce qu'on utilise, dans la ou les couches, des amines aromatiques tertiaires, des oxadiazoles, des thiadiazoles, des benzoxazoles, des benzotriazoles, des phtalocyanines, des systèmes aromatiques condensés ou des polyènes comportant des groupements pouvant être polymérisés par voie radicalaire, anionique ou cationique, en tant que composés de transfert de charge.

12. Dispositif électroluminescent selon l'une quelconque des revendications 1 à 4 caractérisé en ce qu'on utilise, dans la ou les couches, des amines aromatiques tertiaires, des oxadiazoles, des thiadiazoles, des benzoxazoles, des benzotriazoles, des phtalocyanines, des systèmes aromatiques condensés ou des polyènes comportant des groupements aptes à la photocycloaddition, en tant que composés de transfert de charge.

13. Dispositif électroluminescent selon la revendication 11, caractérisé en ce que l'on utilise les composés comportant des groupements pouvant être polymérisés par voie radicalaire, en tant que composés de transfert de charge.

14. Dispositif électroluminescent selon la revendication 13, caractérisé en ce que les composés de transfert de charge portent des restes vinyle éventuellement substitués en tant que groupements pouvant être polymérisés par voie radicalaire.

15. Dispositif électroluminescent selon la revendication 14, caractérisé en ce que les restes vinyle éventuellement substitués contiennent ou sont des groupements vinylcarbonylés.

16. Dispositif électroluminescent selon la revendication 12, caractérisé en ce que les groupements aptes à la photocycloaddition contiennent les structures éventuellement substituées 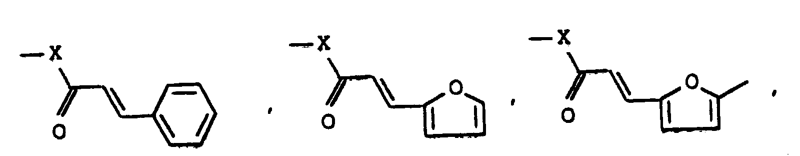 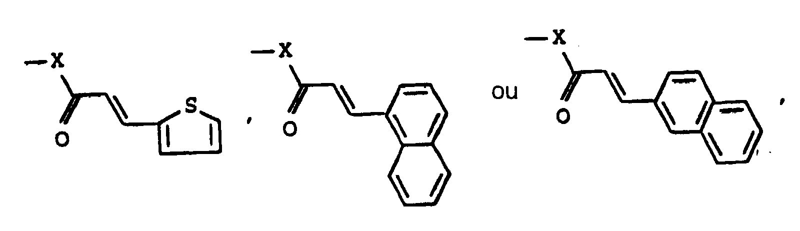 dans lesquelles X représente O ou NR et R représente un atome d'hydrogène ou un groupement alkyle en C₁-C₆.

17. Dispositif électroluminescent selon la revendication 10, caractérisé en ce qu'on utilise des composés triarylsubstitués en tant qu'amine aromatique tertiaire.

18. Dispositif électroluminescent selon l'une quelconque des revendications 1 à 4 caractérisé en ce qu'une ou plusieurs couches sont obtenues par réticulation thermique.

19. Dispositif électroluminescent selon la revendication 18, caractérisé en la réticulation thermique est menée à des températures de 50-250°C, de préférence 60-150°C.
